# EUROPÄISCHE PATENTSCHRIFT

(11) **EP 1 697 483 B1**
(45) Veröffentlichungstag und Bekanntmachung des Hinweises auf die Patenterteilung: **09.10.2019**
(21) Anmeldenummer: 04798062.8
(22) Anmeldetag: 24.11.2004
(51) Int. Cl.: C09K 11/06, H01L 51/30, H05B 33/14, C07F 15/00

(54) **ORGANISCHES ELEKTROLUMINESZENZELEMENT**
ORGANIC ELECTROLUMINESCENT ELEMENT
ELEMENT ELECTROLUMINESCENT ORGANIQUE

(30) Priorität: 05.12.2003 DE 10357315
(43) Veröffentlichungstag der Anmeldung: 06.09.2006
(73) Patentinhaber: Merck Patent GmbH, 64293 Darmstadt (DE)
(72) Erfinder: VESTWEBER, Horst, 34830 Gilserberg-Winterscheid (DE); GERHARD, Anja, 97209 Veitshöchheim (DE); STÖSSEL, Philipp, 65929 Frankfurt (DE)
(86) Internationale Anmeldenummer: PCT/EP2004/013312
(87) Internationale Veröffentlichungsnummer: WO 2005/054403

(56) Entgegenhaltungen:
- EP-A- 1 353 388
- US-A1- 2002 015 859
- US-A1- 2002 125 818
- PATENT ABSTRACTS OF JAPAN Bd. 1998, Nr. 14, 31. Dezember 1998 (1998-12-31) & JP 10 231479 A (OKI ELECTRIC IND CO LTD), 2. September 1998 (1998-09-02)
- TOKITO S ET AL: "Influence of hole transporting material on device performance in organic light-emitting diode" THIN SOLID FILMS, ELSEVIER-SEQUOIA S.A. LAUSANNE, CH, Bd. 363, Nr. 1-2, März 2000 (2000-03), Seiten 290-293, XP004189329 ISSN: 0040-6090
- SALBECK J ET AL: "Low molecular organic glasses for blue electroluminescence" SYNTHETIC METALS, ELSEVIER SEQUOIA, LAUSANNE, CH, Bd. 91, 1997, Seiten 209-215, XP002277588 ISSN: 0379-6779
- SPREITZER H ET AL: "WHITE AND BLUE TEMPERATURE STABILE AND EFFICIENT OLEDS USING AMORPHOUS SPIRO TRANSPORT AND SPIRO EMITTING COMPOUNDS" PROCEEDINGS OF THE SPIE, SPIE, BELLINGHAM, VA, US, Bd. 4105, 31. Juli 2000 (2000-07-31), Seiten 125-133, XP008017672 ISSN: 0277-786X

## Beschreibung

Die vorliegende Erfindung beschreibt ein neuartiges Designprinzip für organische Elektrolumineszenzelemente und dessen Verwendung in darauf basierenden Displays.

In einer Reihe verschiedenartiger Anwendungen, die im weitesten Sinne der Elektronikindustrie zugerechnet werden können, ist der Einsatz organischer Halbleiter als funktionelle Materialien seit geraumer Zeit Realität bzw. wird in naher Zukunft erwartet. So finden schon seit etlichen Jahren lichtsensitive organische Materialien (z. B. Phthalocyanine) sowie organische Ladungstransportmaterialien (i. d. R. Lochtransporter auf Triarylaminbasis) Verwendung in Kopiergeräten. Der Einsatz halbleitender organischer Verbindungen, die zur Emission von Licht im sichtbaren Spektralbereich befähigt sind, steht gerade am Anfang der Markteinführung, zum Beispiel in organischen Elektrolumineszenzvorrichtungen. Deren Einzelbauteile, die organischen lichtemittierenden Dioden (OLEDs), besitzen ein sehr breites Anwendungsspektrum als:
1. weiße oder farbige Hinterleuchtungen für monochrome oder mehrfarbige Anzeigeelemente (wie z. B. im Taschenrechner, Mobiltelefone, etc.),
2. großflächige Anzeigen (wie z. B. Verkehrsschilder, Plakate, etc.),
3. Beleuchtungselemente in allen Farben und Formen,
4. monochrome oder vollfarbige Passiv-Matrix-Displays für tragbare Anwendungen (wie z. B. Mobiltelefone, PDAs, Camcorder, etc.),
5. vollfarbige, großflächige hochaufgelöste Aktiv-Matrix-Displays für verschiedenste Anwendungen (wie z. B. Mobiltelefone, PDAs, Laptops, Fernseher, etc.).
Für einfachere OLEDs enthaltende Vorrichtungen ist die Markteinführung bereits erfolgt, wie die Autoradios der Firma Pioneer, die Mobiltelefone der Firmen Pioneer und SNMD oder eine Digitalkamera der Firma Kodak mit "organischem Display" belegen. Weitere derartige Produkte stehen kurz vor der Einführung. Dennoch sind hier noch deutliche Verbesserungen nötig, um diese Displays zu einer echten Konkurrenz zu den derzeit marktbeherrschenden Flüssigkristallanzeigen (LCD) zu machen bzw. diese zu überflügeln.

Eine Entwicklung hierzu, die sich in den letzten Jahren abzeichnet, ist der Einsatz metallorganischer Komplexe, die Phosphoreszenz statt Fluoreszenz zeigen (M. A. Baldo, S. Lamansky, P. E. Burrows, M. E. Thompson, S. R. Forrest, Appl. Phys. Lett., 1999, 75, 4-6). Aus quantenmechanischen Gründen ist unter Verwendung metallorganischer Verbindungen eine bis zu vierfache Quanten-, Energie- und Leistungseffizienz möglich. Ob sich diese neue Entwicklung durchsetzen wird, hängt zum einen stark davon ab, ob entsprechende Device-Kompositionen gefunden werden, die diese Vorteile (Triplett-Emission = Phosphoreszenz gegenüber Singulett-Emission = Fluoreszenz) auch in den OLEDs umsetzen können. Hier ist nicht nur die Entwicklung der metallorganischen Verbindungen selbst von Bedeutung, sondern vor allem auch von weiteren speziell hierfür benötigten Materialien, wie beispielsweise sogenannte Matrix- oder auch Lochblockiermaterialien. Als wesentliche Bedingungen für die praktische Anwendung sind hier insbesondere eine hohe operative Lebensdauer, eine hohe Stabilität gegenüber thermischer Belastung und eine niedrige Einsatz- und Betriebsspannung verbunden mit einer hohen Leistungseffizienz, um mobile Applikationen zu ermöglichen, zu nennen.

Üblicherweise besteht eine organische Elektrolumineszenzvorrichtung aus mehreren Schichten, die mittels Vakuummethoden oder unterschiedlicher Druckmethoden aufeinander aufgebracht werden. Für phosphoreszierende organische Elektrolumineszenzvorrichtungen sind diese Schichten im Einzelnen:
1. Eine Trägerplatte = Substrat (üblicherweise Glas oder Kunststoffolie).
2. Eine transparente Anode (üblicherweise Indium-Zinn-Oxid, ITO).
3. Eine Lochinjektions-Schicht (**H**ole **I**njection **L**ayer = HIL): z. B. auf der Basis von Kupferphthalocyanin (CuPc) oder leitfähigen Polymeren, wie Polyanilin (PANI) oder Polythiophen-Derivaten (wie PEDOT).
4. Eine oder mehrere Lochtransport-Schichten (**H**ole **T**ransport **L**ayer = HTL): üblicherweise auf der Basis von Triarylamin-Derivaten z. B. 4,4',4"-Tris(N-1-naphthyl)-N-phenyl-amino)-triphenylamin (NaphDATA) als erste Schicht und N,N'-Di(naphth-1-yl)-N,N'-diphenyl-benzidin (NPB) als zweite Lochtransportschicht.
5. Eine oder mehrere Emissions-Schichten (**Em**ission **L**ayer = EML): üblicherweise aus mit Phosphoreszenzfarbstoffen, z. B. Tris(phenylpyridyl)-iridium (Ir(PPy)₃) oder Tris(2-benzothienylpyridyl)-iridium (Ir(BTP)₃), dotierten Matrixmaterialien, wie z. B. 4,4'-Bis(carbazol-9-yl)-biphenyl (CBP). Die Emissions-Schicht kann aber auch aus Polymeren, Mischungen von Polymeren, Mischungen von Polymeren und niedermolekularen Verbindungen oder Mischungen verschiedener niedermolekularer Verbindungen bestehen.
6. Eine Lochblockierschicht (**H**ole-**B**locking-**L**ayer = HBL): üblicherweise aus BCP (2,9-Dimethyl-4,7-diphenyl-1,10-phenanthrolin = Bathocuproin) oder Bis-(2-methyl-8-chinolinolato)-4-(phenylphenolato)-aluminium(III) (BAlq).
7. Eine Elektronentransport-Schicht (**E**lectron **T**ransport **L**ayer = ETL): meist auf Basis von Aluminium-tris-8-hydroxy-chinolinat (AlQ₃).
8. Eine Elektroneninjektions-Schicht (**E**lectron **I**njection **L**ayer = EIL) (auch Isolatorschicht (ISL) genannt): dünne Schicht bestehend aus einem Material mit einer hohen Dielektrizitätskonstanten, wie z. B. LiF, Li₂O, BaF₂, MgO, NaF.
9. Eine Kathode: in der Regel Metalle, Metallkombinationen oder Metallegierungen mit niedriger Austrittsarbeit, z. B. Ca, Ba, Cs, Mg, Al, In, Mg/Ag.
Diese Vorrichtung wird entsprechend (je nach Anwendung) strukturiert, kontaktiert und schließlich auch hermetisch versiegelt, da sich i. d. R. die Lebensdauer derartiger Vorrichtungen bei Anwesenheit von Wasser und/oder Luft drastisch verkürzt. Das Gleiche gilt auch für sogenannte invertierte Strukturen, bei denen das Licht aus der Kathode ausgekoppelt wird. Bei diesen invertierten OLEDs besteht die Anode z. B. aus Al/Ni/NiOx oder Al/Pt/PtOx oder anderen Metall/Metalloxid-Kombinationen, die ein höchstes besetztes Molekülorbital (HOMO) mit einer Energie von größer 5 eV besitzen. Die Kathode besteht dabei aus den gleichen Materialien, die in Punkt 9 und 10 beschrieben sind, mit dem Unterschied, daß das Metall sehr dünn und damit transparent ist. Die Schichtdicke liegt unter 50 nm, besser unter 30 nm, noch besser unter 10 nm. Auf diese transparente Kathode kann noch ein weiteres transparentes Material aufgebracht werden, z. B. ITO (Indium-Zinn-Oxid), IZO (Indium-Zink-Oxid) usw..

Je nach Deviceaufbau können auch mehrere dieser Schichten zusammenfallen, bzw. es muß nicht notwendigerweise jede dieser Schichten vorhanden sein.

JP 10-231479 offenbart die Verwendung von Triazolverbindungen in der Lochblockierschicht organischer Elektrolumineszenzvorrichtungen.

Allerdings gibt es immer noch erhebliche Probleme, die einer dringenden Verbesserung bedürfen:
1. So ist v. a. die operative Lebensdauer von OLEDs immer noch gering, so daß bis dato nur einfache Anwendungen kommerziell realisiert werden konnten.
2. Diese relativ kurze Lebensdauer ergibt noch ein Folgeproblem: Gerade für Vollfarb-Anwendungen ("full-color-displays"), d. h. Displays, welche keine Segmentierungen aufweisen, sondern über die ganze Fläche alle Farben darstellen können, ist es besonders ungünstig, wenn hier die einzelnen Farben unterschiedlich schnell altern, wie dies derzeit der Fall ist. Dies führt dazu, daß es schon vor Ende der o. g. Lebensdauer (die in der Regel durch einen Abfall auf 50 % der Anfangshelligkeit definiert ist) zu einer deutlichen Verschiebung des Weißpunkts kommt, d. h. die Farbtreue der Darstellung im Display sehr schlecht wird. Um dies zu umgehen, definieren einige Displayhersteller die Lebensdauer als 70 % oder 90 %-Lebensdauer (d. h. Abfall der Anfangshelligkeit auf 70 % bzw. auf 90 % des Anfangswertes). Dies führt aber dazu, daß die Lebensdauer noch kürzer wird.
3. Die Effizienzen, insbesondere die Leistungseffizienz (gemessen in lm/W), von OLEDs sind zwar akzeptabel, aber auch hier sind - gerade für tragbare Anwendungen ("portable applications") - immer noch Verbesserungen erwünscht.
4. Die Farbkoordinaten von OLEDs sind nicht gut genug. Besonders die Kombination von guten Farbkoordinaten mit hoher Effizienz muß noch verbessert werden.
5. Die Alterungsprozesse gehen generell mit einem Anstieg der Spannung einher. Dieser Effekt macht spannungsgetriebene organische Elektrolumineszenzvorrichtungen schwierig bzw. unmöglich. Eine stromgetriebene Ansteuerung ist aber gerade in diesem Fall aufwendiger und teurer.
6. Die benötigte Betriebsspannung ist gerade bei effizienten phosphoreszierenden OLEDs recht hoch und muß daher weiter verringert werden, um die Leistungseffizienz zu verbessern. Das ist gerade für tragbare Anwendungen von großer Bedeutung.
7. Der benötigte Betriebsstrom ist ebenfalls in den letzten Jahren verringert worden, muß aber noch weiter verringert werden, um die Leistungseffizienz zu verbessern. Das ist gerade für tragbare Anwendungen besonders wichtig.
8. Der Aufbau der OLEDs ist durch die Vielzahl der organischen Schichten komplex und aufwendig.

Die oben genannten Probleme machen Verbesserungen bei der Herstellung von OLEDs notwendig. Hierbei haben inbesondere Verbesserungen im Bereich der Matrix- und Lochblockiermaterialien große Bedeutung.

Bei phosphoreszierenden OLEDs wird üblicherweise eine Lochblockierschicht (HBL) folgend auf die Emitterschicht zur Steigerung der Effizienz und Lebensdauer verwendet. Diese Devicestrukturen werden zumeist nach dem Kriterium der maximalen Effizienz optimiert. Dabei kommt häufig BCP (Bathocuproin) als Lochblockiermaterial (HBM) zum Einsatz, womit sehr gute Effizienzen erzielt werden (D. F. O'Brien et al., Appl. Phys. Lett. 1999, 74, 442), allerdings mit dem großen Nachteil, daß die Lebensdauer der OLEDs mit BCP stark eingeschränkt ist. T. Tsutsui et al. (Japanese J. Appl. Phys. 1999, 38, L1502) geben als Grund für die eingeschränkte Lebensdauer die geringe Stabilität von BCP an, so daß diese Devices nicht in hochwertigen Displayanwendungen Verwendung finden können. Ein weiteres Lochblockiermaterial ist Bis-(2-methyl-8-hydroxychinolato)-(4-phenylphenolato)-aluminium(III) (BAlq). Damit konnten die Stabilität und die Lebensdauer der Devices deutlich verbessert werden, allerdings mit dem Nachteil, daß die Quanteneffizienz der Devices mit BAlq deutlich (ca. 40 %) niedriger ist als mit BCP (T. Watanabe et al., Proc. SPIE 2001, 4105, 175). Kwong et al. (Appl. Phys. Lett. 2002, 81, 162) erzielten damit Lebensdauern von 10000 h mit Tris(phenylpyridyl)iridium(III). Allerdings zeigte dieses Device eine Effizienz von nur 19 cd/A, was weit hinter dem Stand der Technik zurückliegt. Somit sind mit BAlq zwar gute Lebensdauern möglich, insgesamt ist es jedoch kein zufriedenstellendes Lochblockiermaterial, da die erreichte Effizienz zu niedrig ist.

Wie außerdem aus dem oben beschriebenen Aufbau einer phosphoreszierenden OLED hervorgeht, ist dieser sehr aufwendig, da viele Schichten, die wiederum aus vielen verschiedenen Materialien bestehen, nacheinander aufgebracht werden müssen, was den Herstellungsprozeß von kommerziellen OLEDs sehr kompliziert und komplex macht.

Aus dieser Beschreibung geht klar hervor, daß die bislang verwendeten Lochblockiermaterialien (HBM) BCP und BAlq gemäß dem Stand der Technik zu unbefriedigenden Nebeneffekten führen. Es besteht also weiterhin ein Bedarf an Lochblockiermaterialien, die in OLEDs zu guten Effizienzen führen, gleichzeitig aber auch zu hohen Lebensdauern. Es wurde nun überraschend gefunden, daß OLEDs, die bestimmte - im Folgenden aufgeführte - Materialklassen als Lochblockiermaterialien enthalten, deutliche Verbesserungen gegenüber dem Stand der Technik aufweisen. Mit diesen Materialklassen ist es möglich, gleichzeitig hohe Effizienzen und gute Lebensdauern zu erhalten, was mit Materialien gemäß dem Stand der Technik nicht möglich ist. Zudem wurde gefunden, daß mit den neuen Lochblockiermaterialien nicht notwendigerweise eine separate Elektronentransportschicht verwendet werden muß, was einen technologischen Vorteil darstellt, und daß dadurch zusätzlich die Betriebsspannungen deutlich gesenkt werden können, was einer höheren Leistungseffizienz entspricht.

Gegenstand der Erfindung ist eine organische Elektrolumineszenzvorrichtung gemäß Anspruch 1.

Auch wenn dies aus dem Anspruch 1 hervorgeht, sei hier nochmal explizit darauf hingewiesen, daß A und B dieselbe Struktureinheit Y=X enthalten können, ansonsten aber verschieden sind.

Das oben und im Folgenden verwendete Symbol "=" steht für eine Doppelbindung im Sinne der Lewis-Schreibweise.

Unter einem aromatischen oder heteroaromatischen Ringsystem im Sinne dieser Erfindung soll ein System verstanden werden, das nicht notwendigerweise nur aromatische bzw. heteroaromatische Gruppen enthält, sondern in dem auch mehrere aromatische oder heteroaromatische Gruppen durch eine kurze, nicht aromatische Einheit, wie z. B. ein sp³-hybrididiertes C-, N- oder O-Atom unterbrochen sein können. So sollen also beispielsweise auch Systeme wie 9,9'-Spirobifluoren, 9,9-Diarylfluoren, Triarylamin, Diarylether, etc. im Sinne dieser Anwendung als aromatische Ringsysteme verstanden werden.

Dabei kann es auch bevorzugt sein, wenn das Lochblockiermaterial B mehr als eine Einheit Y=X bzw. mehr als eine Einheit gemäß Formel (2) oder (3) enthält.

Bevorzugt enthält die Lochblockierschicht mindestens 50 % des Lochblockiermaterials B, besonders bevorzugt mindestens 80 %, ganz besonders bevorzugt besteht diese nur aus dem Lochblockiermaterial B.

Als bevorzugte Lochblockiermaterialien B haben sich Verbindungen erwiesen, die in mindestens einem der Reste R¹, R² oder R³ eine aromatische oder heteroaromatische Gruppe tragen, die direkt an Y gebunden ist. Besonders bevorzugt sind Verbindungen, die in allen vorhandenen Resten R¹, R² und R³ aromatische oder heteroaromatische Gruppen tragen, die direkt an Y gebunden sind.

Als besonders geeignete Lochblockiermaterialien B haben sich Verbindungen erwiesen, die nicht planar aufgebaut sind. An der Struktureinheit der Form Y=X können entsprechende Substituenten für eine Abweichung der Gesamtstruktur von der Planarität sorgen. Dies ist insbesondere dann der Fall, wenn mindestens einer der Substituenten R¹, R², R³ und/oder R⁴ wenigstens ein sp³-hybridisiertes Kohlenstoff-, Silicium-, Germanium- und/oder Stickstoffatom enthält, welches dadurch näherungsweise tetraedrische oder im Fall von Stickstoff pyramidale Bindungsgeometrie aufweist.
Um eine deutliche Abweichung von der Planarität zu erreichen, ist es bevorzugt, wenn wenigstens eines der sp³-hybridisierten Atome ein sekundäres, tertiäres oder quartäres Atom ist, besonders bevorzugt ein tertiäres oder quartäres Atom, im Fall von Kohlenstoff, Silicium oder Germanium ganz besonders bevorzugt quartäres Atom ist.
Unter einem sekundären, tertiären oder quartären Atom wird ein Atom mit zwei, drei bzw. vier Substituenten ungleich Wasserstoff verstanden.

Bevorzugt sind Verbindungen, die in mindestens einem der Reste R ein 9,9'-Spirobifluorenderivat, bevorzugt verknüpft über die 2- und/oder 2,7- und/oder 2,2'- und/oder 2,2',7- und/oder 2,2'7,7'-Position, ein 9,9-disubstituiertes Fluorenderivat, bevorzugt verknüpft über die 2- und/oder 2,7-Position, ein 6,6- und/oder 12,12-di- oder tetrasubstituiertes cis- oder trans-Indenofluorenderivat, ein Triptycenderivat, bevorzugt verknüpft über die 9- und/oder 10-Position, ein Dihydrophenanthren-Derivat, bevorzugt verknüpft über die 2- und/oder 2,7-Position, ein Hexaarylbenzolderivat, bevorzugt verknüpft über die p-Position am / an den Aromaten, oder ein Tetraarylmethanderivat, bevorzugt verknüpft über die p-Position am/an den Aromaten, enthalten.

Besonders bevorzugt sind Verbindungen, die in mindestens einem der Reste R¹, R², R³ bzw. R⁴ ein 9,9'-Spirobifluorenderivat oder ein 9,9-disubstituiertes Fluorenderivat enthalten, ganz besonders bevorzugt ein 9,9'-Spirobifluorenderivat.

Weiterer Gegenstand der vorliegenden Erfindung ist die Verwendung von Verbindungen der chemischen Struktureinheit der Formel Y=X, wobei X mindestens ein nicht-bindendes Elektronenpaar aufweist und wobei der Rest X für O und R für einen organischen Rest mit 1 bis 22 Kohlenstoffatomen und für OH, OR, NH₂, NHR⁶ und N(R⁶)₂ steht, mit R⁶ = H oder ein organischer Rest mit 1 bis 20 C-Atomen, und wobei der Rest Y für C oder P steht als Lochblockiermaterial in einer organischen Leuchtdiode.

Bevorzugt ist eine organische Elektrolumineszenzvorrichtung dadurch gekennzeichnet, daß die Matrixmaterialien A aus den Klassen der Carbazole, beispielsweise gemäß WO 00/057676, EP 01202358 und WO 02/074015, der Ketone und Imine, beispielsweise gemäß WO 04/093207, der Phosphinoxide, Phosphinsulfide, Phosphinselenide, der Phosphazene, der Sulfone, der Sulfoxide, beispielsweise gemäß DE 10330761.3, der Silane, der polypodalen Metall-Komplexe, beispielsweise gemäß WO 04/081017, oder der Oligophenylene basierend auf Spirobifluorenen, beispielsweise gemäß EP 676461 und WO 99/40051, ausgewählt sind. Besonders bevorzugt sind Ketone, Phosphinoxide und Sulfoxide.

Diese Auswahl ist für den Erfindungsgegenstand jedoch nicht maßgeblich. So können auch weitere bekannte Materialien, wie Derivate des Carbazols, verwendet werden.

Die oben beschriebene OLED kann noch weitere Schichten enthalten, wie zum Beispiel Lochinjektionsschicht, Lochtransportschicht, Elektroneninjektionsschicht und/oder Elektronentransportschicht. Es sei allerdings darauf verwiesen, daß nicht notwendigerweise alle diese Schichten vorhanden sein müssen. So wurde gefunden, daß erfindungsgemäße OLEDs, die eine Lochblockierschicht, bestehend aus einem Lochblockiermaterial B, enthalten, weiterhin vergleichbar gute Effizienzen und Lebensdauern bei geringerer Betriebsspannung liefern, wenn keine Elektroneninjektions- und Elektronentransportschichten verwendet werden.

Daher sind organische Elektrolumineszenzvorrichtungen bevorzugt, in denen die Lochblockierschicht direkt an die Elektroneninjektionsschicht bzw. Kathode angrenzt.

Weiterhin bevorzugt ist eine organische Elektrolumineszenzvorrichtung dadurch gekennzeichnet, daß als phosphoreszierender Emitter eine Verbindung enthalten ist, die mindestens ein Atom der Ordnungszahl größer 36 und kleiner 84 aufweist.
Besonders bevorzugt ist eine organische Elektrolumineszenzvorrichtung dadurch gekennzeichnet, daß der phosphoreszierende Emitter mindestens ein Element der Ordnungszahl größer 56 und kleiner 80, ganz besonders bevorzugt Molybdän, Wolfram, Rhenium, Ruthenium, Osmium, Rhodium, Iridium, Palladium, Platin, Silber, Gold und/oder Europium, beispielsweise gemäß WO 98/01011, US 02/0034656, US 03/0022019, WO 00/70655, WO 01/41512, WO 02/02714, WO 02/15645, EP 1191613, EP 1191612, EP 1191614, WO 03/040257, WO 03/084972 und WO 04/026886, enthält.

Weiterhin bevorzugt ist eine organische Elektrolumineszenzvorrichtung dadurch gekennzeichnet, daß die Glasübergangstemperatur T_{g} des Lochblockiermaterials B größer als 100 °C, bevorzugt größer 120 °C, ganz besonders bevorzugt größer 140 °C ist.

Weiterhin bevorzugt ist eine organische Elektrolumineszenzvorrichtung dadurch gekennzeichnet, daß eine oder mehrere Schichten mit einem Sublimationsverfahren beschichtet werden. Dabei werden die niedermolekularen Materialien in Vakuum-Sublimationsanlagen bei einem Druck kleiner 10⁻⁵ mbar, bevorzugt kleiner 10⁻⁶ mbar, besonders bevorzugt kleiner 10⁻⁷ mbar aufgedampft.

Bevorzugt ist ebenfalls eine organische Elektrolumineszenzvorrichtung dadurch gekennzeichnet, daß eine oder mehrere Schichten mit dem OVPD (Organic Vapour Phase Deposition) Verfahren oder mit Hilfe einer Trägergassublimation beschichtet werden, die dem Fachmann bekannt sind. Dabei werden die niedermolekularen Materialien bei einem Druck zwischen 10⁻⁵ mbar und 1 bar aufgebracht.

Weiterhin bevorzugt ist eine organische Elektrolumineszenzvorrichtung dadurch gekennzeichnet, daß eine oder mehrere Schichten mit einem beliebigen Druck-verfahren, wie z. B. Flexodruck oder Offsetdruck, besonders bevorzugt LITI (Light Induced Thermal Imaging, Thermotransferdruck) oder Ink-Jet Druck (Tintenstrahl-Druck), beschichtet werden.

Die oben beschriebenen emittierenden Vorrichtungen weisen folgende überraschende Vorteile gegenüber dem Stand der Technik auf:
1. Die Effizienz entsprechender Vorrichtungen wird höher im Vergleich zu Systemen, die nicht dem erfindungsgemäßen Design folgen.
2. Die Stabilität und damit die Lebensdauer entsprechender Vorrichtungen wird höher im Vergleich zu Systemen, die nicht dem erfindungsgemäßen Design folgen.
3. Die Betriebsspannungen werden wesentlich erniedrigt. Dadurch erhöht sich die Leistungseffizienz. Dies gilt insbesondere, wenn keine separate Elektronentransportschicht verwendet wird.
4. Die Schichtaufbau ist einfacher, da mindestens eine organische Schicht, nämlich die Elektronentransportschicht, weniger verwendet werden kann, was in Folge zu einem geringerem Produktionsaufwand führt. Dies ist ein erheblicher Vorteil im Produktionsprozeß, da bei der herkömmlichen Herstellungsweise in der Regel für jede organische Schicht eine separate Aufdampfanlage verwendet wird, wodurch mindestens eine derartige Anlage somit eingespart wird bzw. komplett entfällt.

Im vorliegenden Anmeldetext und auch in den weiteren folgenden Beispielen wird nur auf organische Leuchtdioden und die entsprechenden Displays abgezielt. Trotz dieser Beschränkung der Beschreibung ist es für den Fachmann ohne weiteres erfinderisches Zutun möglich, das entsprechende erfindungsgemäße Design auch für andere, verwandte Vorrichtungen, z. B. für organische Solarzellen (O-SCs), organische Feldeffekttransistoren (O-FETs) oder auch organische Laserdioden (O-Laser), um nur einige weitere Anwendungen zu nennen, zu verwenden. Diese sind ebenfalls Gegenstand der vorliegenden Erfindung.

### Beispiele:

### Herstellung und Charakterisierung von organischen Elektrolumineszenzvorrichtungen, die dem erfindungsgemäßen Aufbau entsprechen.

Die Herstellung der OLEDs erfolgte nach dem im Folgenden skizzierten allgemeinen Verfahren. Dieses wurde im Einzelfall auf die jeweiligen Gegebenheiten (z. B. Schichtdickenvariation, um optimale Effizienz bzw. Farbe zu erreichen) angepaßt. Erfindungsgemäße Elektrolumineszenzvorrichtungen können, wie beispielsweise in DE10330761.3 beschrieben, dargestellt werden.
In den folgenden Beispielen werden die Ergebnisse verschiedener OLEDs vorgestellt. Der grundlegende Aufbau, wie die verwendeten Materialien und Schichtdicken, außer der EML und HBL, waren zur besseren Vergleichbarkeit identisch. Analog dem o. g. allgemeinen Verfahren wurden emittierende OLEDs mit folgendem Aufbau erzeugt:

| | |
|---|---|
| PEDOT (HIL) | 60 nm (aus Wasser aufgeschleudert; PEDOT bezogen von H C. Starck; Poly-[3,4-ethylendioxy-2,5-thiophen]) |
| NaphDATA (HTM) | 20 nm (aufgedampft; NaphDATA bezogen von SynTec; 4,4',4"-Tris(N-1-naphthyl-N-phenyl-amino)-triphenylamin |
| S-TAD (HTM) | 20 nm (aufgedampft; S-TAD hergestellt nach WO 99/12888; 2,2',7,7'-Tetrakis(diphenylamino)-spirobifluoren) |
| Emitter-Schicht (EML) | 30 nm (genauer Aufbau: siehe Beispiele in Tabelle 1) |
| Lochblockierschicht (HBL) | 10 nm (siehe Beispiele in Tabelle 1) |
| AlQ₃ (ETL) | 20 nm (aufgedampft: AlQ₃ bezogen von SynTec; Tris(chinolinato)aluminium(III)); nicht in allen Beispielen verwendet |
| Ba-Al (Kathode) | 3 nm Ba, darauf 150 nm Al |

Diese noch nicht optimierten OLEDs wurden standardmäßig charakterisiert; hierfür wurden die Elektrolumineszenzspektren, die Effizienz (gemessen in cd/A), die Leistungseffizienz (gemessen in lm/W) in Abhängigkeit der Helligkeit, berechnet aus Strom-Spannungs-Helligkeit-Kennlinien (IUL-Kennlinien), und die Lebensdauer bestimmt. Unter Lebensdauer versteht man die Zeit, nach der die Anfangshelligkeit der OLED bei einer konstanten Stromdichte von 10 mA/cm² auf die Hälfte gesunken ist.
In Tabelle 1 sind die Ergebnisse verschiedener Beispiele zusammengefaßt. Die Zusammensetzung der EML und HBL inklusive der entsprechenden Schichtdicken ist aufgeführt. Die dotierten phosphoreszierenden EMLs enthalten als Matrixmaterial **A1** die Verbindung Bis(9,9'-spirobifluoren-2-yl)keton (synthetisiert gemäß WO 04/093207), als Matrixmaterial **A2** die Verbindung Bis(9,9'-spirobifluoren-2-yl)-phenyl-phosphinoxid (synthetisiert gemäß DE 10330761.3), als Matrixmaterial **A3** 2,7-Bis(2-spiro-9,9'-bifluorenyl-carbonyl)-spiro-9,9'-bifluoren (synthetisiert gemäß WO 04/093207) oder als Matrixmaterial **A4** CBP (4,4'-Bis(N-carbazolyl)biphenyl), als Emitter die Verbindungen Ir(PPy)₃ oder Ir(piq)₃ (beide synthetisiert gemäß WO 02/060910) und als Lochblockiermaterial **B1** die Verbindung Bis(9,9'-spirobifluoren-2-yl)keton, als Lochblockiermaterial **B2** die Verbindung Bis(9,9'-spirobifluoren-2-yl)-phenyl-phosphinoxid oder als Lochblockiermaterial **B3** die Verbindung 2,7-Bis(2-spiro-9,9'-bifluorenyl-carbonyl)-spiro-9,9'-bifluoren. Als Vergleichsbeispiele dienen OLEDs, die als Lochblockiermaterial B-Alq enthalten. In der untenstehenden Abbildung sind die entsprechenden Strukturformeln der verwendeten Substanzen dargestellt.

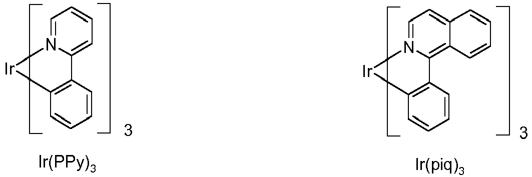

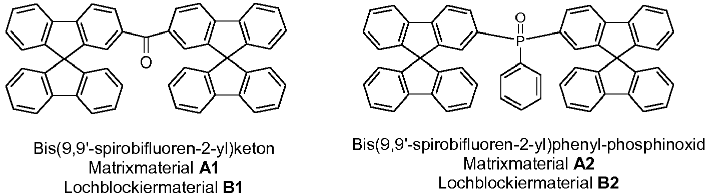

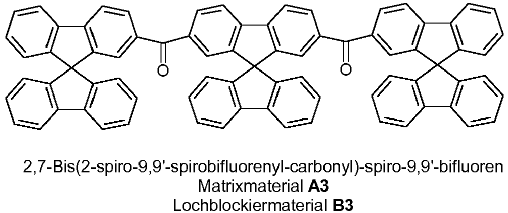

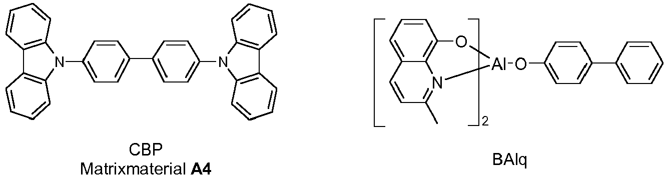

**Tabelle 1:**

| Experiment | EML | HBL | ETL | Max. Effizienz (cd/A) | Max. Leistungseffizienz (Im/W) | Spannung (V) bei 100 cd/m² | Lebensdauer (h) bei 10 mA/cm² |
|---|---|---|---|---|---|---|---|
| Beispiel 1a | **A2**:10% IrPPy | **B1** | AlQ₃ | 29.1 | 16.5 | 4.7 | 630 |
| Beispiel 1b (Vergleich) | **A2**:10% IrPPy | **BAlq** | AlQ₃ | 25.2 | 14.8 | 5.7 | 510 |
| Beispiel 2 a | **A2**:10% IrPPy | **B1** | - | 30.2 | 19.1 | 3.5 | 710 |
| Beispiel 2 b (Vergleich) | **A2**:10% IrPPy | **BAlq** | - | 24.8 | 14.7 | 5.2 | 240 |
| Beispiel 3 | **A3**:10% Ir(piq)₃ | **B1** | AlQ₃ | 7.3 | 7.1 | 4.9 | ca. 23000 (extrapoliert) |
| Beispiel 4a | **A3**:10% Ir(piq)₃ | **B1** | - | 7.5 | 8.1 | 4.5 | ca. 18000 (extrapoliert) |
| Beispiel 4b (Vergleich) | **A3**:10% Ir(piq)₃ | **BAlq** | - | 6.6 | 5.4 | 5.5 | ca. 2600 (extrapoliert) |
| Beispiel 5 | **A1**:10% IrPPy | **B2** | AlQ₃ | 34.0 | 26.9 | 4.1 | 590 |
| Beispiel 6 | **A1**:10% IrPPy | **B2** | - | 32.7 | 27.7 | 3.5 | 490 |
| Beispiel 7 a | **CBP**:10% IrPPy | **B2** | AlQ₃ | 29.7 | 17.2 | 4.5 | 650 |
| Beispiel 7 b (Vergleich) | **CBP**:10% IrPPy | **BAlq** | AlQ₃ | 18.3 | 8.5 | 5.1 | 250 |
| Beispiel 8 a | **CBP**:10% IrPPy | **B2** | - | 27.2 | 15.9 | 5.1 | 330 |
| Beispiel 8 b (Vergleich) | **CBP**:10% IrPPy | **BAlq** | - | 16.5 | 8.8 | 5.3 | 180 |
| Beispiel 9 | **A1**:10% IrPPy | **B3** | AlQ₃ | 30.5 | 25.0 | 4.8 | 450 |
| Beispiel 10 | **A1**:10% Ir(piq)₃ | **B3** | AlQ₃ | 6.5 | 6.4 | 5.1 | ca. 25000 (extrapoliert) |
| Beispiel 11 a | **A1**:10% Ir(piq)₃ | **B3** | - | 7.5 | 8.1 | 4.5 | ca. 20000 (extrapoliert) |
| Beispiel 11 b (Vergleich) | **A1**:10% Ir(piq)₃ | **BAlq** | - | 6.1 | 5.2 | 5.6 | ca. 5000 (extrapoliert) |

Die OLEDs zeigen grüne Emission aus dem Dotanden Ir(PPy)₃ bzw. rote Emission aus dem Dotanden Ir(piq)₃.
In allen Beispielen zeigt sich eine deutliche Verbesserung der Effizienz und Lebensdauer bei verringerter Betriebsspannung im Vergleich zu Vorrichtungen gemäß dem Stand der Technik, die B-Alq als Lochblockiermaterial enthalten.
Ein ähnlicher Trend zeigt sich auch, wenn keine separate ETL verwendet wird. Bei den OLEDs gemäß dem Stand der Technik nimmt die photometrische Effizienz ab und die Lebensdauer verkürzt sich deutlich im Vergleich zu OLEDs mit ETL. Dies ist nicht der Fall bei den OLEDs gefertigt nach dem neuen Designprinzip. Hier sinken vor allem die Spannungen, wodurch sich die Leistungseffizienz verbessert.

Zusammenfassend kann gesagt werden, daß OLEDs gefertigt nach dem neuen Designprinzip eine höhere Effizienz bei niedrigerer Spannung und längerer Lebensdauer aufweisen, wie man leicht Tabelle 1 entnehmen kann.

## Patentansprüche

1. Organische Elektrolumineszenzvorrichtung, enthaltend Anode, Kathode und mindestens eine Emissionsschicht, enthaltend mindestens ein Matrixmaterial A, welches mit mindestens einem phosphoreszierenden Emitter dotiert ist, wobei der phosphoreszierende Emitter Iridium enthält, und mindestens eine Lochblockierschicht, enthaltend mindestens ein Lochblockiermaterial B, **dadurch gekennzeichnet, daß** das Lochblockiermaterial B wenigstens eine chemische Struktureinheit der Formel Y=X enthält, wobei das Lochblockiermaterial B die Formeln (2) oder (3) gemäß dem Schema 1 aufweist 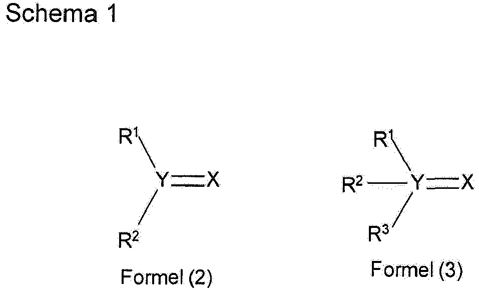 wobei die verwendeten Symbole folgende Bedeutung haben:
Y ist C oder P;
X ist O;
R¹, R², R³ ist bei jedem Auftreten gleich oder verschieden H, F, CN, N(R⁴)₂, eine geradkettige, verzweigte oder cyclische Alkyl-, Alkoxy- oder Thioalkoxygruppe mit 1 bis 40 C-Atomen, die mit R⁵ substituiert oder auch unsubstituiert sein kann, wobei ein oder mehrere nicht benachbarte CH₂-Gruppen durch -R⁶C=CR⁶-, -C≡C-, Si(R⁶)₂, Ge(R⁶)₂, Sn(R⁶)₂, C=O, C=S, C=Se, C=NR⁶, -O-, -S-, -NR⁶- oder -CONR⁶- ersetzt sein können und wobei ein oder mehrere H-Atome durch F, Cl, Br, I, CN oder NO₂ ersetzt sein können, oder ein aromatisches oder heteroaromatisches Ringsystem oder eine Aryloxy- oder Heteroaryloxygruppe mit 1 bis 40 aromatischen C-Atomen, die durch einen oder mehrere Reste R⁵ substituiert sein können; dabei können mehrere Substituenten R¹, R² und/oder R³ miteinander ein mono- oder polycyclisches, aliphatisches oder aromatisches Ringsystem bilden; oder ein über eine bivalente Gruppe -Z- gebundenes aromatisches bzw. heteroaromatisches Ringsystem oder eine Aryloxy- oder Heteroaryloxygruppe jeweils mit 1 bis 40 aromatischen C-Atomen, wobei ein oder mehrere H-Atome durch F, Cl, Br oder I ersetzt sein können oder die durch einen oder mehrere nicht aromatische Reste R⁴ substituiert sein kann, wobei mehrere Substituenten R⁴ ein weiteres mono- oder polycyclisches, aliphatisches oder aromatisches Ringsystem aufspannen können;
R⁴ ist bei jedem Auftreten gleich oder verschieden eine geradkettige, verzweigte oder cyclische Alkyl- oder Alkoxykette mit 1 bis 22 C-Atomen, in der auch ein oder mehrere nicht benachbarte C-Atome durch -R⁶C=CR⁶-, -C≡C-, Si(R⁶)₂, Ge(R⁶)₂,
Sn(R⁶)₂, -NR⁶-, -O-, -S-, -CO-O-, -O-CO-O- ersetzt sein können, wobei auch ein oder mehrere H-Atome durch Fluor ersetzt sein können, eine Aryl-, Heteroaryl- oder Aryloxygruppe mit 1 bis 40 C-Atomen, welche auch durch einen oder mehrere Reste R⁶ substituiert sein kann oder OH oder N(R⁵)₂;
R⁵ ist bei jedem Auftreten gleich oder verschieden R⁴ oder CN, B(R⁶)₂ oder Si(R⁶)₃;
R⁶ ist bei jedem Auftreten gleich oder verschieden H oder ein aliphatischer oder aromatischer Kohlenwasserstoffrest mit 1 bis 20 C-Atomen;
Z ist ein geradkettiger, verzweigter oder cyclischer, bevorzugt konjugierter Rest mit 1 bis 40 C-Atomen, der bevorzugt in Konjugation mit den beiden anderen Substituenten steht, wobei bevorzugt die Anzahl der Atome von Z, die die Gruppe gemäß Formel (1) und den aromatischen Rest verknüpfen, eine gerade Zahl beträgt, wobei ein oder mehrere nicht benachbarte C-Atome durch -O-, -S- oder -NR¹-ersetzt sein können und ein oder mehrere C-Atome durch einen Rest R¹ oder Halogen substituiert sein können;
und mit der Maßgabe, daß die Molmasse des Lochblockiermaterials B größer als 150 g/mol ist und mit der Maßgabe, daß das Matrixmaterial A nicht identisch dem Lochblockiermaterial B ist.

2. Organische Elektrolumineszenvorrichtung gemäß Anspruch 1, **dadurch gekennzeichnet, daß** die Lochblockierschicht nur aus dem Lochblockiermaterial B besteht.

3. Organische Elektrolumineszenzvorrichtung gemäß Anspruch 1 oder 2, **dadurch gekennzeichnet, daß** die Verbindungen des Lochblockiermaterials B nicht planar aufgebaut sind.

4. Organische Elektrolumineszenzvorrichtung gemäß einem oder mehreren der Ansprüche 1 bis 3, **dadurch gekennzeichnet, daß** im Lochblockiermaterial B mindestens einer der Substituent R¹ bis R⁴ mindestens ein sp³-hybridisiertes Kohlenstoffatom enthält.

5. Organische Elektrolumineszenzvorrichtung gemäß Anspruch 4, **dadurch gekennzeichnet, daß** das sp³-hybridisierte Kohlenstoffatom ein sekundäres, tertiäres oder quartäres Kohlenstoffatom ist.

6. Organische Elektrolumineszenzvorrichtung gemäß Anspruch 5, **dadurch gekennzeichnet, daß** das sp³-hybridisierte Kohlenstoffatom ein quartäres Kohlenstoffatom ist.

7. Organische Elektrolumineszenzvorrichtung gemäß einem oder mehreren der Ansprüche 1 bis 6, **dadurch gekennzeichnet, daß** in mindestens einem der Reste R¹ bis R⁴ ein 9,9'-Spirobifluorenderivat, ein 9,9-disubstituiertes Fluorenderivat, ein Indenofluorenderivat, ein Triptycenderivat, 9,10-Dihydrophenanthrenderivat, ein Hexaarylbenzolderivat oder ein Tetraarylmethanderivat enthalten ist.

8. Organische Elektrolumineszenzvorrichtung gemäß einem oder mehreren der Ansprüche 1 bis 7, **dadurch gekennzeichnet, daß** die Matrixmaterialien A aus der Gruppe der Carbazole, Silane, der polypodalen Metall-Komplexe, der Oligophenylene basierend auf Spirobifluorenen, der Ketone, Imine, Phosphinoxide, Phosphinsulfide, Phosphinselenide, Phosphazene, Sulfone oder Sulfoxide ausgewählt sind.

9. Organische Elektrolumineszenzvorrichtung gemäß einem oder mehreren der Ansprüche 1 bis 8, **dadurch gekennzeichnet, daß** die Lochblockierschicht direkt an die Elektroneninjektionsschicht bzw. Kathode angrenzt.

10. Verfahren zur Herstellung einer organischen Elektrolumineszenzvorrichtung gemäß einem oder mehreren der Ansprüche 1 bis 9, **dadurch gekennzeichnet, daß** eine oder mehrere Schichten mit einem Sublimationsverfahren, mit dem OVPD (Organic Vapour Phase Deposition) Verfahren, mit einem Druckverfahren, bevorzugt mit dem Ink-Jet (Tintenstrahldruck) Verfahren oder dem LITI (Light Induced Thermal Imaging) Verfahren, beschichtet werden.

11. Verwendung von Verbindungen gemäß Anspruch 1 als Lochblockiermaterial in einem elektronischen Bauteil, insbesondere in einer organischen Leuchtdiode, organischen Solarzelle, einem organischen Feldeffekttransistor, organischen Dünnfilmtransistor, einer organischen integrierten Schaltung oder einer organischen Laserdiode.

12. Organische Solarzelle, organischer Feldeffekttransistor, organischer Dünnfilmtransistor, organische integrierte Schaltung oder organische Laserdiode, **dadurch gekennzeichnet, daß** der Aufbau einem oder mehreren der Ansprüche 1 bis 9 genügt.

## Claims

1. Organic electroluminescent device comprising anode, cathode and at least one emission layer comprising at least one matrix material A which is doped with at least one phosphorescent emitter, where the phosphorescent emitter contains iridium, and at least one hole-blocking layer comprising at least one hole-blocking material B, **characterised in that** the hole-blocking material B contains at least one chemical structural unit of the formula Y=X, where the hole-blocking material B has the formula (2) or (3) according to Scheme 1 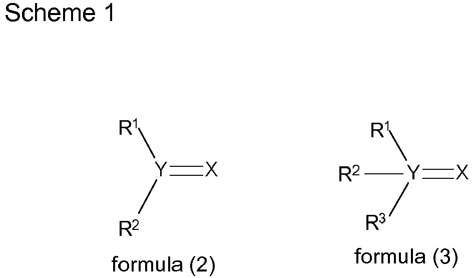 where the symbols used have the following meaning:
Y is C or P;
X is O;
R¹, R², R³ are on each occurrence, identically or differently, H, F, CN, N(R⁴)₂, a straight-chain, branched or cyclic alkyl, alkoxy or thioalkoxy group having 1 to 40 C atoms, which may be substituted by R⁵ or also unsubstituted, in which one or more non-adjacent CH₂ groups may be replaced by -R⁶C=CR⁶-, -C≡C-, Si(R⁶)₂, Ge(R⁶)₂, Sn(R⁶)₂, C=O, C=S, C=Se, C=NR⁶, -O-, -S-, -NR⁶- or -CONR⁶- and in which one or more H atoms may be replaced by F, Cl, Br, I, CN or NO₂, or an aromatic or heteroaromatic ring system or an aryloxy or heteroaryloxy group having 1 to 40 aromatic C atoms, which may be substituted by one or more radicals R⁵; a plurality of substituents R¹, R² and/or R³ may form a mono- or polycyclic, aliphatic or aromatic ring system with one another; or an aromatic or heteroaromatic ring system bonded via a divalent group -Z-, or an aryloxy or heteroaryloxy group, in each case having 1 to 40 aromatic C atoms, in which one or more H atoms may be replaced by F, Cl, Br or I or which may be substituted by one or more non-aromatic radicals R⁴, where a plurality of substituents R⁴ may form a further mono- or polycyclic, aliphatic or aromatic ring system;
R⁴ is on each occurrence, identically or differently, a straight-chain, branched or cyclic alkyl or alkoxy chain having 1 to 22 C atoms, in which, in addition, one or more non-adjacent C atoms may be replaced by -R⁶C=CR⁶-, -C≡C-, Si(R⁶)₂, Ge(R⁶)₂, Sn(R⁶)₂, -NR⁶-, -O-, -S-, -CO-O- or -O-CO-O- and in which one or more H atoms may be replaced by fluorine, an aryl, heteroaryl or aryloxy group having 1 to 40 C atoms, which may also be substituted by one or more radicals R⁶, or OH or N(R⁵)₂;
R⁵ is on each occurrence, identically or differently, R⁴ or CN, B(R⁶)₂ or Si(R⁶)₃;
R⁶ is on each occurrence, identically or differently, H or an aliphatic or aromatic hydrocarbon radical having 1 to 20 C atoms;
Z is a straight-chain, branched or cyclic, preferably conjugated radical having 1 to 40 C atoms, which is preferably in conjugation with the two other substituents, where the number of atoms of Z that link the group of the formula (1) and the aromatic radical is preferably an even number, where one or more non-adjacent C atoms may be replaced by -O-, -S- or -NR¹- and one or more C atoms may be substituted by a radical R¹ or halogen;
and with the proviso that the molecular weight of the hole-blocking material B is greater than 150 g/mol and with the proviso that the matrix material A is not identical with the hole-blocking material B.

2. Organic electroluminescent device according to Claim 1, **characterised in that** the hole-blocking layer consists only of the hole-blocking material B.

3. Organic electroluminescent device according to Claim 1 or 2, **characterised in that** the compounds of the hole-blocking material B do not have a planar structure.

4. Organic electroluminescent device according to one or more of Claims 1 to 3, **characterised in that** at least one of the substituents R¹ to R⁴ in the hole-blocking material B contains at least one sp³-hybridised carbon atom.

5. Organic electroluminescent device according to Claim 4, **characterised in that** the sp³-hybridised carbon atom is a secondary, tertiary or quaternary carbon atom.

6. Organic electroluminescent device according to Claim 5, **characterised in that** the sp³-hybridised carbon atom is a quaternary carbon atom.

7. Organic electroluminescent device according to one or more of Claims 1 to 6, **characterised in that** at least one of the radicals R¹ to R⁴ contains a 9,9'-spiro-bifluorene derivative, a 9,9-disubstituted fluorene derivative, an indenofluorene derivative, a triptycene derivative, a 9,10-dihydrophenanthrene derivative, a hexa-arylbenzene derivative or a tetraarylmethane derivative.

8. Organic electroluminescent device according to one or more of Claims 1 to 7, **characterised in that** the matrix materials A are selected from the group of the carbazoles, silanes, polypodal metal complexes, oligophenylenes based on spiro-bifluorenes, ketones, imines, phosphine oxides, phosphine sulfides, phosphine selenides, phosphazenes, sulfones or sulfoxides.

9. Organic electroluminescent device according to one or more of Claims 1 to 8, **characterised in that** the hole-blocking layer is directly adjacent to the electron-injection layer or cathode.

10. Process for the production of an organic electroluminescent device according to one or more of Claims 1 to 9, **characterised in that** one or more layers are applied by a sublimation process, by the OVPD (organic vapour phase deposition) process, by a printing process, preferably by the ink-jet printing process, or the LITI (light induced thermal imaging) process.

11. Use of compounds according to Claim 1 as hole-blocking material in an electronic component, in particular in an organic light-emitting diode, organic solar cell, organic field-effect transistor, organic thin-film transistor, organic integrated circuit or organic laser diode.

12. Organic solar cell, organic field-effect transistor, organic thin-film transistor, organic integrated circuit or organic laser diode, **characterised in that** the structure satisfies one or more of Claims 1 to 9.

## Revendications

1. Dispositif électroluminescent organique comprenant une anode, une cathode et au moins une couche d'émission qui comprend au moins un matériau de matrice A qui est dopé avec au moins un émetteur phosphorescent, dans lequel l'émetteur phosphorescent contient de l'iridium, et au moins une couche de blocage de trous qui comprend au moins un matériau de blocage de trous B, **caractérisé en ce que** le matériau de blocage de trous B contient au moins une unité structurelle chimique de la formule Y=X, dans lequel le matériau de blocage de trous B présente la formule (2) ou (3) conformément au Schéma 1 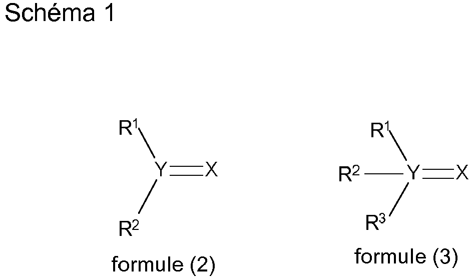 dans lesquelles les symboles qui sont utilisés présentent les significations qui suivent :
Y est C ou P ;
X est O;
R¹, R², R³ sont pour chaque occurrence, de manière identique ou différente, H, F, CN, N(R⁴)₂, un groupe alkyle, alcoxy ou thioalcoxy en chaîne droite, ramifié ou cyclique qui comporte de 1 à 40 atome(s) de C, lequel peut être substitué par R⁵ ou peut également être non substitué, où un ou plusieurs groupe(s) CH₂ non adjacents peut/peuvent être remplacé(s) par -R⁶C=CR⁶-, -C≡C-, Si(R⁶)₂, Ge(R⁶)₂, Sn(R⁶)₂, C=O, C=S, C=Se, C=NR⁶, -O-, -S-, -NR⁶- ou -CONR⁶- et où un ou plusieurs atome(s) de H peut/peuvent être remplacé(s) par F, Cl, Br, I, CN ou NO₂, ou un système de cycle aromatique ou hétéroaromatique ou un groupe aryloxy ou hétéroaryloxy qui comporte de 1 à 40 atome(s) de C aromatique(s), lequel peut être substitué par un radical ou par plusieurs radicaux R⁵; une pluralité de substituants R¹, R² et/ou R³ peuvent former un système de cycle aliphatique ou aromatique mono- ou polycyclique les uns avec les autres ; ou un système de cycle aromatique ou hétéroaromatique qui est lié via un groupe divalent -Z-, ou un groupe aryloxy ou hétéroaryloxy, dans chaque cas qui comporte de 1 à 40 atome(s) de C aromatique(s), où un ou plusieurs atome(s) de H peut/peuvent être remplacé(s) par F, Cl, Br ou I ou lequel peut être substitué par un radical ou par plusieurs radicaux non aromatique(s) R⁴, où une pluralité de substituants R⁴ peuvent former un autre système de cycle aliphatique ou aromatique mono- ou polycyclique ;
R⁴ est pour chaque occurrence, de manière identique ou différente, une chaîne alkyle ou alcoxy en chaîne droite, ramifiée ou cyclique qui comporte de 1 à 22 atome(s) de C, où, en outre, un ou plusieurs atome(s) de C non adjacents peut/peuvent être remplacé(s) par -R⁶C=CR⁶-, -C≡C-, SiR⁶)₂, Ge(R⁶)₂, Sn(R⁶)₂, -NR⁶-, -O-, -S-, -CO-O- ou -O-CO-O- et où un ou plusieurs atome(s) de H peut/peuvent être remplacé(s) par fluor, un groupe aryle, hétéroaryle ou aryloxy qui comporte de 1 à 40 atome(s) de C, lequel peut également être substitué par un radical ou par plusieurs radicaux R⁶, ou OH ou N(R⁵)₂ ;
R⁵ est pour chaque occurrence, de manière identique ou différente, R⁴ ou CN, B(R⁶)₂ ou Si(R⁶)₃ ;
R⁶ est pour chaque occurrence, de manière identique ou différente, H ou un radical hydrocarbone aliphatique ou aromatique qui comporte de 1 à 20 atome(s) de C ;
Z est un radical en chaîne droite, ramifié ou cyclique, de préférence conjugué qui comporte de 1 à 40 atome(s) de C, lequel est de préférence en conjugaison avec les deux autres substituants, où le nombre d'atomes de Z qui lient le groupe de la formule (1) et le radical aromatique est de préférence un nombre pair, où un ou plusieurs atome(s) de C non adjacents peut/peuvent être remplacé(s) par -O-, -S- ou -NR¹- et un ou plusieurs atome(s) de C peut/peuvent être substitué(s) par un radical R¹ ou par halogène ;
étant entendu que le poids moléculaire du matériau de blocage de trous B est supérieur à 150 g/mol et étant entendu que le matériau de matrice A n'est pas identique au matériau de blocage de trous B.

2. Dispositif électroluminescent organique selon la revendication 1, **caractérisé en ce que** la couche de blocage de trous est constituée seulement par le matériau de blocage de trous B.

3. Dispositif électroluminescent organique selon la revendication 1 ou 2, **caractérisé en ce que** les composés du matériau de blocage de trous B ne présentent pas une structure plane.

4. Dispositif électroluminescent organique selon une ou plusieurs des revendications 1 à 3, **caractérisé en ce qu'**au moins l'un des substituants R¹ à R⁴ dans le matériau de blocage de trous B contient au moins un atome de carbone sp³-hybridisé.

5. Dispositif électroluminescent organique selon la revendication 4, **caractérisé en ce que** l'atome de carbone sp³-hybridisé est un atome de carbone secondaire, tertiaire ou quaternaire.

6. Dispositif électroluminescent organique selon la revendication 5, **caractérisé en ce que** l'atome de carbone sp³-hybridisé est un atome de carbone quaternaire.

7. Dispositif électroluminescent organique selon une ou plusieurs des revendications 1 à 6, **caractérisé en ce qu'**au moins l'un des radicaux R¹ à R⁴ contient un dérivé de 9,9'-spirobifluorène, un dérivé de 9,9-fluorène disubstitué, un dérivé d'indénofluorène, un dérivé de triptycène, un dérivé de 9,10-dihydrophénanthrène, un dérivé d'hexaarylbenzène ou un dérivé de tétraarylméthane.

8. Dispositif électroluminescent organique selon une ou plusieurs des revendications 1 à 7, **caractérisé en ce que** les matériaux de matrice A sont sélectionnés parmi le groupe constitué par les carbazoles, les silanes, les complexes métalliques polypodaux, les oligophénylènes basés sur les spirobifluorènes, les cétones, les imines, les oxydes de phosphine, les sulfures de phosphine, les séléniures de phosphine, les phosphazènes, les sulfones ou les sulfoxydes.

9. Dispositif électroluminescent organique selon une ou plusieurs des revendications 1 à 8, **caractérisé en ce que** la couche de blocage de trous est directement adjacente à la couche d'injection d'électrons ou à la cathode.

10. Procédé pour la fabrication d'un dispositif électroluminescent organique selon une ou plusieurs des revendications 1 à 9, **caractérisé en ce qu'**une ou plusieurs couche(s) est/sont appliquée(s) au moyen d'un processus de sublimation, au moyen du processus OVPD (dépôt organique en phase vapeur), au moyen d'un processus d'impression, de préférence au moyen du processus d'impression par jet d'encre, ou au moyen du processus LITI (imagerie thermique induite au moyen de la lumière).

11. Utilisation de composés selon la revendication 1 en tant que matériau de blocage de trous dans un composant électronique, en particulier dans une diode émettrice de lumière organique, une cellule solaire organique, un transistor à effet de champ organique, un transistor à film mince organique, un circuit intégré organique ou une diode laser organique.

12. Cellule solaire organique, transistor à effet de champ organique, transistor à film mince organique, circuit intégré organique ou diode laser organique, caractérisé(e) en ce que la structure satisfait une ou plusieurs des revendications 1 à 9.
